# EUROPEAN PATENT APPLICATION

(11) **EP 2 128 848 A1**
(43) Date of publication of application: **02.12.2009**
(21) Application number: 09160325.8
(22) Date of filing: 15.05.2009
(51) Int. Cl.: G09G 3/32, G09G 3/20

(54) **Pixel and organic light emiting display using the same**

(30) Priority: 28.05.2008 KR 20080049710
(71) Applicant: Samsung Mobile Display Co., Ltd., Yongin-City Gyunggi-do (KR)
(72) Inventor: Kim, Do-Ik, Gyunggi-do (KR); Lee, Wang-Jo, Gyunggi-do (KR)
(74) Representative: Gulde Hengelhaupt Ziebig & Schneider

(57) **Abstract**

A pixel and an organic light emitting display using the same are provided. The display displays an image having desired gray levels while allowing the voltage of data signals to be reduced. The pixel includes an organic light emitting diode; a driving transistor for supplying a current to the organic light emitting diode; a switching transistor configured to supply a data signal from a data line to a gate electrode of the driving transistor based on a scan signal from a scan line; a storage capacitor coupled between the gate electrode of the driving transistor and a source electrode of the driving transistor; and an initialization transistor coupled between the source electrode of the driving transistor and an initialization power voltage.

## Description

### BACKGROUND

### 1. Field of the Invention

The present invention relates to a pixel and an organic light emitting display using the same, and more particularly, to a pixel and an organic light emitting display using the same for displaying an image having a desired gray level.

### 2. Discussion of Related Art

Recently, there have been various types of flat panel display devices having reduced weight and volume as compared to cathode ray tubes. Such flat panel display devices include liquid crystal displays, field emission displays, plasma display devices, and organic light emitting displays, among others.

Among these flat panel displays, the organic light emitting display displays images using organic light emitting diodes (OLEDs) that emit light through the recombination of electrons and holes. The organic light emitting display device has a relatively fast response speed and may be driven with relatively low power consumption.

Currently, P-type (e.g., PMOS) transistors are typically used in pixels of the organic light emitting display. However, manufacturing costs associated with manufacturing P-type transistors are generally higher. In order to reduce costs, when a transistor is formed of an oxidized substance (e.g., an oxide), the transistors may be N-type (e.g., NMOS) transistors. Such N-type transistors may be developed with lower prices.

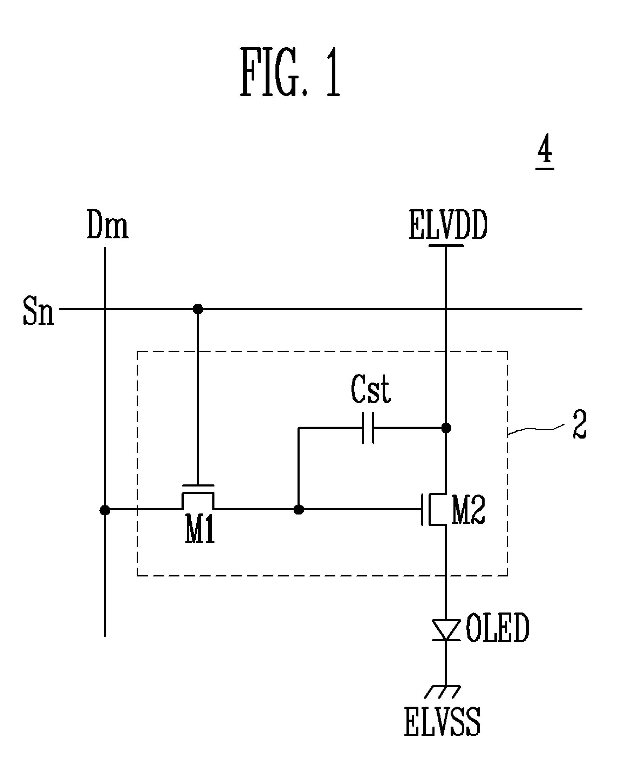

FIG. 1 is a circuit diagram showing a conventional pixel in an organic light emitting display but including N-type transistors instead of P-type transistors. As will be apparent from the following explanations, it is problematic to replace the P-type transistors by N-type transistors.

Referring to FIG. 1, the conventional pixel 4 includes an organic light emitting diode OLED and a pixel circuit 2 coupled to data and scan lines Dm and Sn to control the organic light emitting diode OLED.

An anode electrode of the organic light emitting diode OLED is coupled to the pixel circuit 2, and a cathode electrode of the organic light emitting diode OLED is coupled to a second power source ELVSS. The organic light emitting diode OLED emits light with a luminance corresponding to a current supplied from the pixel circuit 2.

When a scan signal is supplied to the scan line Sn, the pixel circuit 2 controls an amount of current supplied to the organic light emitting diode OLED corresponding to a data signal supplied to the data line Dm. The pixel circuit 2 includes a second transistor (e.g., a driving transistor) M2 coupled between a first power source ELVDD and the organic light emitting diode OLED; a first transistor (e.g., a switching transistor) M1 coupled between a gate electrode of the second transistor M2 and the data line Dm, and having a gate electrode coupled to the scan line Sn; and a storage capacitor Cst coupled between a gate electrode of the second transistor M2 and a first electrode of the second transistor M2.

A gate electrode of the first transistor M1 is coupled to the scan line Sn, and a first electrode of the first transistor M1 is coupled to the data line Dm. A second electrode of the first transistor M1 is coupled to one terminal of the storage capacitor Cst. Here, the first electrode is either a source or drain electrode, and the second electrode is the other of the source and drain electrodes. For example, if the first electrode is the source electrode, the second electrode is the drain electrode.

When a scan signal is supplied from the scan line Sn, the first transistor M1 coupled to the data line Dm is turned on to supply a data signal from the data line Dm to the storage capacitor Cst. At this time, a voltage corresponding to the data signal is charged into the storage capacitor Cst.

The gate electrode of the second transistor M2 is coupled to one terminal of the storage capacitor Cst, and the first electrode of the second transistor M2 is coupled to the other terminal of the storage capacitor Cst and the first power source ELVDD. A second electrode of the second transistor M2 is coupled to an anode electrode of the organic light emitting diode OLED. The second transistor M2 controls an amount of current supplied to the organic light emitting diode OLED from the first power source ELVDD, corresponding to a voltage value stored in the storage capacitor Cst. At this time, the organic light emitting diode OLED emits light corresponding to the amount of current supplied from the second transistor M2.

If the conventional pixel 4 is utilized in an analog driving configuration (i.e., implementation of gray levels using the magnitude of data signals), a desired current may not be accurately supplied. More specifically, in the conventional pixel 4, if the source electrode of the second transistor M2 is coupled to the organic light emitting diode OLED, the second transistor M2 may not be driven as a constant current source due to changes in voltage applied to the organic light emitting diode OLED (i.e., variations in Vgs of the second transistor M2). Further, since the Vgs of the second transistor M2 is changed corresponding to deterioration of the organic light emitting diode OLED, an image having a desired gray level may not be accurately displayed.

If the conventional pixel 4 is utilized in a digital driving configuration manner (i.e., driving one frame divided into a plurality of sub-frames), the data signal should have a high voltage value. More specifically, in the digital driving configuration, the second transistor M2 is driven as a switch performing a turn-on or turn-off operation. Therefore, the data signal should have a voltage higher than ELVDD+Vth (M2), for the second transistor M2 to be turned on. In this case, a data driver for supplying data signals should be designed to have a high voltage resistance so that data signals are stably supplied. Accordingly, manufacturing costs may be increased. Further, if data signals have high voltages, power consumption may be increased due to charge and discharge of such high voltage data signals.

### SUMMARY OF THE INVENTION

Accordingly, aspects of an embodiment according to the present invention provides a pixel and an organic light emitting display using the same that displays an image having a desired gray level and allows the voltage of a data signal to be lowered reduced.
According to a first aspect of the present invention, a pixel is provided comprising an organic light emitting diode, first and second transistors, and a storage capacitor. The first transistor has a first electrode connected to a data line and a gate electrode connected to a scan line. The second transistor has a gate electrode connected to a second electrode of the first transistor, a first electrode connected to a first power supply for providing a first supply voltage, and a second electrode connected to the organic light emitting diode. The storage capacitor has a first electrode connected to the gate electrode of the second transistor and a second electrode connected to the second electrode of the second transistor. According to the invention the pixel further comprises a third transistor having a gate electrode connected to the scan line, a first electrode connected to the second electrode of the second transistor, and a second electrode connected to an initialisation power supply for providing an initialisation voltage.

According to a second aspect of the present invention, an organic light emitting display is provided, comprising a scan driver, a data driver, and a plurality of pixels. The scan driver is adapted to supply scan signals to a plurality of scan lines, the scan lines extending in a first direction. The data driver is adapted to supply data signals to a plurality of data lines, the data lines extending in a second direction crossing the first direction. The pixels are positioned at crossing regions of the scan and data lines and are pixels according to the first aspect of the invention.

### BRIEF DESCRIPTION OF THE DRAWINGS

The accompanying drawings, together with the specification, illustrate certain exemplary embodiments of the present invention, and, together with the description, serve to explain the principles of the present invention.

FIG. 1 is a circuit diagram showing a conventional pixel.

FIG. 2 is a schematic block diagram of an organic light emitting display according to an embodiment of the present invention.

FIG. 3 illustrates one frame in a digital driving configuration.

FIG. 4 is a circuit diagram showing an embodiment of a pixel shown in FIG. 2.

FIG. 5 illustrates an example of a driving waveform for driving a pixel of FIG. 4.

### DETAILED DESCRIPTION OF EXEMPLARY EMBODIMENTS

Hereinafter, certain exemplary embodiments according to the present invention will be described with reference to the accompanying drawings. Here, when a first element is described as being coupled to a second element, the first element may be directly coupled to the second element or may alternatively be coupled to the second element via one or more additional elements. Further, some of the elements that are not essential to a complete understanding of the invention are omitted for clarity. Also, like reference numerals refer to like elements throughout.

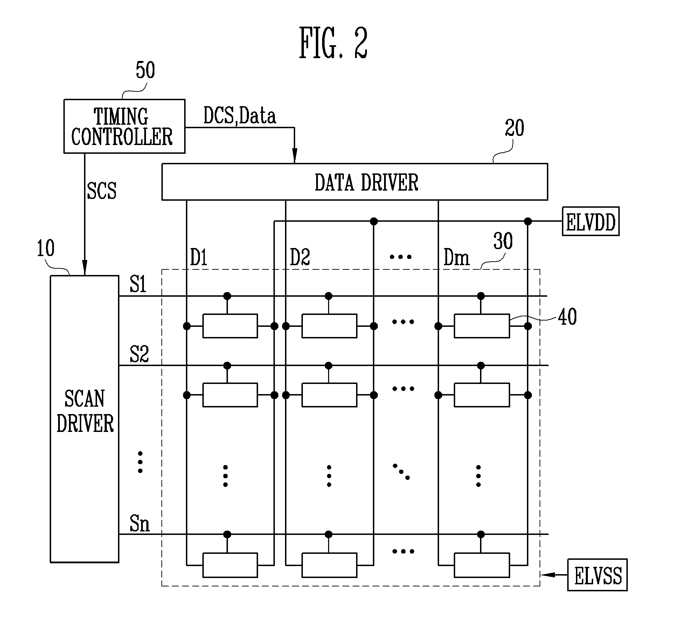

FIG. 2 is a schematic block diagram of an organic light emitting display according to an embodiment of the present invention.

Referring to FIG. 2, the organic light emitting display according to the embodiment of the present invention includes a display unit 30 having a plurality of pixels 40 coupled to scan lines S1 to Sn and data lines D1 to Dm; a scan driver 10 for driving the scan lines S1 to Sn; a data driver 20 for driving the data lines D1 to Dm; and a timing controller 50 for controlling the scan driver 10 and the data driver 20.

The timing controller 50 generates a data driving control signal DCS and a scan driving control signal SCS corresponding to external synchronization signals. The data driving control signal DCS is supplied to the data driver 20, and the scan driving control signal SCS is supplied to the scan driver 10. The timing controller 50 may further supply external data to the data driver 20.

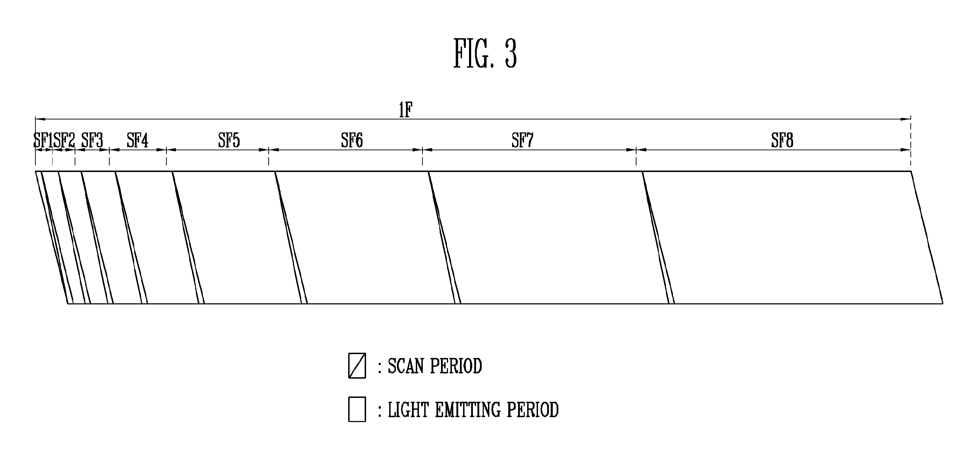

In an analog driving configuration, the scan driver 10 sequentially supplies a scan signal (high level) to the scan lines S1 to Sn during one frame period. In a digital driving configuration, the scan driver 10 may supply a scan signal to one or more of scan lines S1 to Sn for each scan period of a plurality of sub-frames included in one frame 1 F, as shown in, for example, FIG. 3.

The data driver 20 supplies data signals to the data lines D1 to Dm in synchronization with the scan signals. The data signals are applied to the pixels 40 selected by the scan signal. In the analog driving configuration, the data driver 20 supplies data signals having a plurality of different voltage values, corresponding to different gray levels, to the data lines D1 to Dm. In the digital driving configuration, the data driver 20 supplies either a first data signal for which the pixels 40 emit light or a second data signal for which the pixels 40 do not emit light to the data lines D1 to Dm.

The pixel unit 30 receives first power ELVDD and second power ELVSS externally. Each of the pixels 40 is connected to the first power ELVDD and second power ELVSS, receives a data signal in accordance with a scan signal, and supplies current corresponding to the supplied data signal to an organic light emitting diode included in each of the pixels 40.

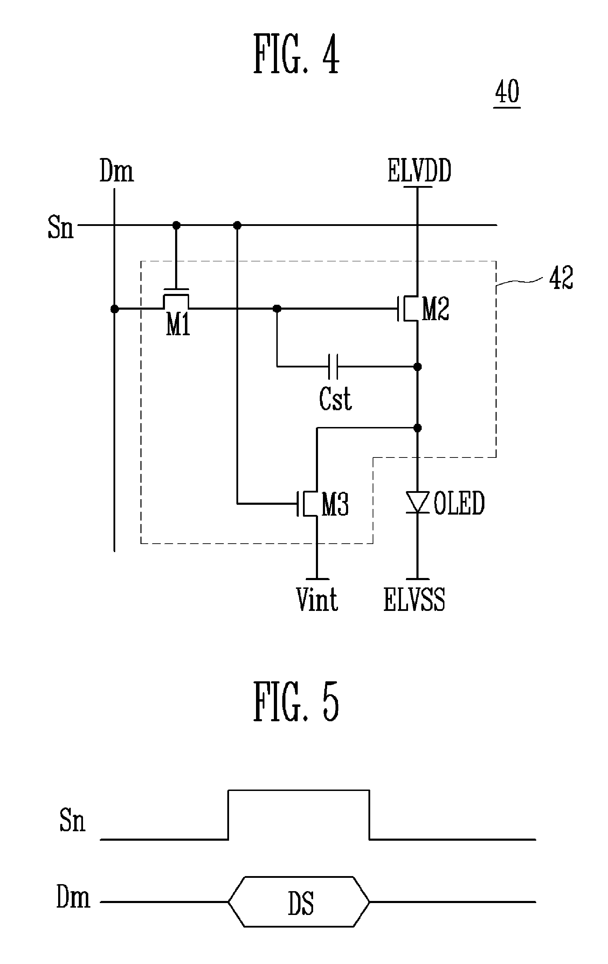

FIG. 4 is a circuit diagram showing an embodiment of a pixel, for example, a pixel 40 shown in FIG. 2. The pixel 40 shown in FIG. 4 is configured with only N-type (e.g., NMOS) transistors.

Referring to FIG. 4, the pixel 40 according to an embodiment of the present invention includes an organic light emitting diode OLED, and a pixel circuit 42 coupled to a data line Dm, a scan line Sn, and the organic light emitting diode OLED.

An anode electrode of the organic light emitting diode OLED is coupled to the pixel circuit 42, and a cathode electrode of the organic light emitting diode OLED is coupled to a second power source ELVSS. The organic light emitting diode OLED emits light with a luminance corresponding to a current supplied from the pixel circuit 42.

When a scan signal is supplied to the scan line Sn, the pixel circuit 42 controls an amount of current supplied to the organic light emitting diode OLED in accordance with a data signal supplied to the data line Dm at the time when the scan signal is supplied. The pixel circuit 42 includes a second transistor (e.g., a driving transistor) M2 coupled between a first power source ELVDD and the organic light emitting diode OLED; a first transistor (e.g., a switching transistor) M1 coupled between a gate electrode of the second transistor M2 and the data line Dm, and having a gate electrode coupled to the scan line Sn; a storage capacitor Cst coupled between a gate electrode of the second transistor M2 and a first electrode of the second transistor M2; and a third transistor (e.g., an initialization transistor) M3 coupled between the first electrode of the second transistor M2 and initialization power Vint.

A gate electrode of the first transistor M1 is coupled to the scan line Sn, and a first electrode of the first transistor M1 is coupled to the data line Dm. A second electrode of the first transistor M1 is coupled to one terminal of the storage capacitor Cst. When a scan signal is supplied to the scan line Sn, the first transistor M1 is turned on to supply the data signal from the data line Dm to the storage capacitor Cst.

The gate electrode of the second transistor M2 is coupled to the one terminal of the storage capacitor Cst, and a second electrode of the second transistor M2 is coupled to the first power source ELVDD. The first electrode of the second transistor M2 is coupled to the anode electrode of the organic light emitting diode OLED. The second transistor M2 controls an amount of current supplied to the second power source ELVSS via the organic light emitting diode OLED from the first power source ELVDD, corresponding to a voltage value stored in the storage capacitor Cst. At this time, the organic light emitting diode OLED emits light corresponding to an amount of current supplied from the second transistor M2.

The storage capacitor Cst is coupled between the gate electrode of the second transistor M2 and the first electrode of the second transistor M2. A voltage corresponding to the data signal is charged in the storage capacitor Cst.

A first electrode of the third transistor M3 is coupled to the first electrode of the second transistor M2, and a second electrode of the third transistor M3 is coupled to the initialization power Vint. A gate electrode of the third transistor M3 is coupled to the scan line Sn. When a scan signal is supplied to the scan line Sn, the third transistor M3 is turned on to supply an initialization power Vint to the first electrode of the second transistor M2. Here, the initialization power Vint is set to have a voltage equal to or less than the second power source ELVSS.

FIG. 5 is a waveform diagram illustrating a method for driving a pixel, for example, the pixel 40 shown in FIG. 4.

An operation process will now be described in detail in conjunction with FIGS. 4 and 5. When a scan signal is supplied to the scan line Sn, the first and third transistors M1 and M3 are turned on. When the first transistor M1 is on, a data signal DS is supplied to the gate electrode of the second transistor M2. When the third transistor M3 is on, the initialization power Vint is supplied to the first electrode of the second transistor M2.

At this time, a voltage corresponding to a voltage difference between the data signal Ds and the initialization power Vint is charged in the storage capacitor Cst. That is, the voltage charged in the storage capacitor Cst is not affected by the organic light emitting diode OLED.

Thereafter, when the supply of the scan signal is stopped, the first and third transistors M1 and M3 are turned off. The second transistor M2 supplies an amount of current based on the voltage charged into the storage capacitor Cst to the organic light emitting diode OLED. At this time, the voltage of the first electrode of the second transistor M2 is adjusted based on a voltage drop across the organic light emitting diode OLED. Since the gate electrode of the second transistor M2 is in a floating state, the voltage charged in the storage capacitor Cst is not changed.

If the pixel 40 of the described embodiment is applied to an analog driving configuration, the voltage charged in the storage capacitor Cst is always maintained constantly, or substantially constantly, so that the second transistor M2 is driven as a constant, or substantially constant, current source. Since the voltage charged in the storage capacitor Cst is always maintained constantly, an image having a desired gray level can be more effectively displayed.

If the pixel 40 of the described embodiment is applied to a digital driving configuration, the voltage of an applied data signal can be lowered. In practice, if the pixel 40 of the present invention is applied to the digital driving configuration, the voltage of the data signal for effectively turning on the second transistor M2 should be higher than the threshold voltage of the second transistor M2. In this example, the voltage of the data signal may be lower than ELVDD+Vth (M2) and higher than Vth (M2).

More specifically, although the second transistor M2 is turned on, the storage capacitor Cst allows a voltage charged during an earlier period to be stably maintained. Therefore, when the second transistor M2 is turned on to increase the voltage of the first electrode of the second transistor M2 (for example, to increase the voltage from the initialization power Vint to the first power ELVDD), the voltage of the gate electrode of the second transistor M2 is also increased corresponding to the increase of the voltage of the first electrode of the second transistor M2. Accordingly, if the voltage of the data signal is set to be higher than the threshold voltage of the second transistor M2, the second transistor M2 can be stably turned on.

Furthermore, if the voltage of the data signal is set to be higher than the threshold voltage of the second transistor M2, a data driver driving a pixel having PMOS transistors may be applied to the pixel 40 of the present invention. Accordingly, extra manufacturing costs due to development of a new data driver may be avoided. In the present invention, since the voltage of a data signal is lower than that of a comparable data signal in a conventional pixel, power consumption from charging and discharging data signals may be minimized or reduced when the pixel of the present invention is applied to a digital driving configuration.

Meanwhile, in the structure of the pixel 40 shown in FIG. 4, the organic light emitting diode OLED may be positioned between the second electrode of the second transistor M2 and the first power source ELVDD, and the third transistor M3 may be removed. However, such an arrangement may require the structure of the organic light emitting diode OLED to be entirely modified and redeveloped. If the structure of the organic light emitting diode OLED is entirely modified, process conditions and the like may require adjustments, and a desirable yield may not be obtainable. Practically, through current processes, it may be difficult to place the organic light emitting diode OLED between the second electrode of the second transistor M2 and the first power source ELVDD.

## Claims

1. A pixel (40) comprising:
an organic light emitting diode (OLED);
a first transistor (M1) having a first electrode connected to a data line (Dm) and a gate electrode connected to a scan line (Sn);
a second transistor (M2) having a gate electrode connected to a second electrode of the first transistor (M1), a first electrode connected to a first power supply (ELVDD) for providing a first supply voltage, and a second electrode connected to the organic light emitting diode (OLED); and
a storage capacitor (Cst) having a first electrode connected to the gate electrode of the second transistor (M2) and a second electrode connected to the second electrode of the second transistor (M2),
**characterised by**
a third transistor (M3) having a gate electrode connected to the scan line (Sn), a first electrode connected to the second electrode of the second transistor (M2), and a second electrode connected to an initialisation power (Vint) supply for providing an initialisation voltage.

2. The pixel (40) of claim 1, wherein a cathode of the organic light emitting diode (OLED) is directly connected to a second power supply (ELVSS) for providing a second supply voltage lower than the first supply voltage.

3. The pixel (40) of one of the claims 1 or 2, wherein each of the transistors are N-type transistors.

4. The pixel (40) of one of the preceding claims, wherein the second transistor (M2) is configured to supply current to the organic light emitting diode (OLED) in accordance with a voltage stored in the storage capacitor (Cst).

5. The pixel (40) of claim 2 or of claim 2 and one of the claims 3 or 4, wherein the initialisation voltage has a voltage level equal to or lower than the second supply voltage.

6. An organic light emitting display, comprising:
a scan driver (10) adapted to supply scan signals to a plurality of scan lines (S1...Sn), the scan lines (S1...Sn) extending in a first direction;
a data driver (20) adapted to supply data signals to a plurality of data lines (D1...Dm), the data lines (D1...Dm) extending in a second direction crossing the first direction; and
a plurality of pixels (40) positioned at crossing regions of the scan and data lines (S1...Sn, D1...Dm), **characterised in that** the pixels (40) are pixels (40) according to one of the preceding claims.

7. The organic light emitting display of claim 6, wherein the scan driver (10) is configured to sequentially supply a scan signal to the plurality of scan lines (S1...Sn) during a frame period.

8. The organic light emitting display of claim 6, wherein the scan driver (10) is configured to supply a scan signal to one or more scan lines (S1...Sn) for a scan period of each of a plurality of sub-frames of a frame.

9. The organic light emitting display of one of the claims 5 through 8, wherein the data driver (20) is configured to supply to each of the data lines (D1...Dm) one of a first data signal for which a corresponding one of the pixels (40) emits light and a second data signal for which the corresponding one of the pixels (40) does not emit light.

10. The organic light emitting display of claim 9, wherein the voltage of the first data signal is lower than a sum of a voltage of the first power source and a threshold voltage of the second transistor (M2), and higher than the threshold voltage of the second transistor (M2).
